# EUROPÄISCHE PATENTSCHRIFT

(11) **EP 2 035 843 B1**
(45) Veröffentlichungstag und Bekanntmachung des Hinweises auf die Patenterteilung: **19.01.2011**
(21) Anmeldenummer: 07726079.2
(22) Anmeldetag: 19.06.2007
(51) Int. Cl.: G01R 27/28, G01R 35/00

(54) **VERFAHREN ZUR KALIBRIERUNG SOWIE VERFAHREN ZUM BESTIMMEN VON STREUPARAMETERN MIT EINER HF-MESSVORRICHTUNG**
METHOD FOR CALIBRATION , AND METHOD FOR DETERMINING SCATTERING PARAMETERS WITH AN HF MEASUREMENT SYSTEM
PROCÉDÉ D'ÉTALONNAGE, ET PROCÉDÉ DE DÉTERMINATION DES PARAMÈTRES DE DISPERSION AVEC UN DISPOSITIF DE MESURE HAUTE FRÉQUENCE

(30) Priorität: 03.07.2006 DE 102006030630
(43) Veröffentlichungstag der Anmeldung: 18.03.2009
(73) Patentinhaber: Rosenberger Hochfrequenztechnik GmbH & Co. KG, 83413 Fridolfing (DE)
(72) Erfinder: ZELDER, Thomas, 21337 Lüneburg (DE)
(74) Vertreter: Zeitler - Volpert - Kandlbinder
(86) Internationale Anmeldenummer: PCT/EP2007/005393
(87) Internationale Veröffentlichungsnummer: WO 2008/003399

(56) Entgegenhaltungen:
- US-A- 5 608 330

## Beschreibung

Die Erfindung betrifft ein Verfahren zum Kalibrieren einer Hochfrequenz-Messvorrichtung (HF - Messvorrichtung) mit N Messtoren, wobei N eine ganze Zahl ≥ 1 ist, insbesondere eines Vektornetzwerkanalysators, zum Bestimmen von Streuparametern eines Messobjektes mit einer n-Tor Messung, wobei n eine ganze Zahl ≥ 1 ist, wobei in eine mit dem Messobjekt oder mit einer das Messobjekt enthaltenden Schaltung verbundene erste elektrischen Leitung ein Hochfrequenz-Testsignal (HF-Testsignal) eingespeist wird, wobei für jedes Tor von einer mit dem Messobjekt verbundenen zweiten elektrischen Leitung, insbesondere einer planaren Leitung, an einer ersten Koppelposition sowie an einer von der ersten Koppelposition beabstandeten zweiten Koppelposition ein über die zweite elektrische Leitung laufendes Hochfrequenzsignal (HF-Signal) ausgekoppelt wird, wobei aus den beiden an den beiden Koppelstellen ausgekoppelten HF-Signalen in jedem Tor jeweils pro Mess- oder Koppelstelle eine Amplitude und/oder eine Phase in Bezug auf das HF-Testsignal eines auf der zweiten elektrischen Leitung zum Messobjekt hinlaufenden HF-Signals sowie eines auf der zweiten elektrischen Leitung von dem Messobjekt weglaufenden HF-Signals bestimmt und daraus Streuparameter des Messobjektes berechnet werden, gemäß dem Oberbegriff des Anspruchs 1.

Die Erfindung betrifft ferner ein Verfahren zum Bestimmen von Streuparametern eines Messobjektes mit einer n-Tor Messung, wobei n eine ganze Zahl ≥ 1 ist, mittels einer Hochfrequenz-Messvorrichtung (HF- Messvorrichtung) mit N Messtoren, wobei N eine ganze Zahl ≥ 1 ist, wobei in eine mit dem Messobjekt oder mit einer das Messobjekt enthaltenden Schaltung verbundene erste elektrischen Leitung ein Hochfrequenz-Testsignal (HF-Testsignal) eingespeist wird, wobei für jedes Tor von einer mit dem Messobjekt verbundenen zweiten elektrischen Leitung, insbesondere einer planaren Leitung, an einer ersten Koppelposition sowie an einer von der ersten Koppelposition beabstandeten zweiten Koppelposition der zweiten elektrischen Leitung ein über die zweite elektrische Leitung laufendes Hochfrequenzsignal (HF-Signal) ausgekoppelt wird, wobei aus den beiden an den beiden Koppelstellen ausgekoppelten HF-Signalen in jedem Tor jeweils pro Koppelstelle eine Amplitude und/oder eine Phase in Bezug auf das HF-Testsignal eines auf der zweiten elektrischen Leitung zum Messobjekt hinlaufenden HF-Signals sowie eines auf der zweiten elektrischen Leitung von dem Messobjekt weglaufenden HF-Signals bestimmt und daraus Streuparameter des Messobjektes berechnet werden, gemäß dem Oberbegriff des Anspruchs 12.

Aus der DE 103 08 280 A1 ist ein gattungsgemäßes Verfahren zum Kalibrieren einer HF-Messvorrichtung, ein gattungsgemäßes Verfahren zum Bestimmen der Streuparameter und eine gattungsgemäße HF-Messvorrichtung bekannt. Bei der Entwicklung von komplexen planaren Mikrowellenschaltungen, welche aus mehreren Unterschaltkreisen aufgebaut sind, ist es nützlich, die Streuparameter für jeden Unterschaltkreis separat zu bestimmen. Hierdurch kann die Leistungsfähigkeit der verschiedenen Unterschaltkreise individuell analysiert und überprüft werden. Dies kann in vorteilhafter Weise über kontaktlose Messverfahren realisiert werden. Mittels kontaktloser Messsonden wird ein Teil der komplexen Signalenergie auf einer planaren, elektrischen Übertragungsleitung vor und hinter dem zu messenden Messobjekt (DUT = Device Under Test) ausgekoppelt und an einen Empfänger übermittelt. Aus diesen ausgekoppelten Signalen werden dann die Streuparameter berechnet. Die Systemdynamik derartiger Messanordnungen hängt jedoch sehr stark von dem Abstand zwischen zwei kontaktlosen Messsonden ab. Daher sind diese Messanordnungen nur in einem schmalen Frequenzband anwendbar. In Dokument US 5608330 wird ein entsprechendes Verfahren zum Kalibrieren eines zwei Meßtore und mindestens vier Meßrtellen aufweisenden vektoriellen Netzwerkanalysators beschrieben.

Der Erfindung liegt die Aufgabe zugrunde, ein Verfahren sowie eine HF-Messvorrichtung der o.g. Art hinsichtlich der Messgenauigkeit über eine große Bandbreite zu verbessern.

Diese Aufgabe wird erfindungsgemäß durch ein Kalibrierverfahren der o.g. Art mit den in Anspruch 1 gekennzeichneten Merkmalen, durch ein Verfahren zum Bestimmen von Streuparametern der o.g. Art mit den in Anspruch 12 gekennzeichneten Merkmalen gelöst. Vorteilhafte Ausgestaltungen der Erfindung sind in den weiteren Ansprüchen beschrieben.

Bei einem Kalibrierverfahren der o.g. Art ist es erfindungsgemäß vorgesehen, dass für wenigstens eines der Tore der HF-Messvorrichtung das auf der zweiten elektrischen Leitung laufende HF-Signal an wenigstens drei voneinander beabstandeten Koppelpositionen ausgekoppelt wird, wobei für jede paarweise Kombination der wenigstens drei Koppelpositionen mit einem vorbestimmten Kalibrierverfahren mit wenigstens einem Kalibrierstandard als Messobjekt, dessen Streuparameter bekannt ist, wenigstens ein Streuparameter für wenigstens eine Frequenz des HF-Testsignals bestimmt wird, wobei die für alle paarweisen Kombinationen bei einer Frequenz des HF-Testsignals bestimmten Werte für den wenigstens einen Streuparameter mit dem für den Kalibrierstandard bekannten Wert für diesen wenigstens einen Streuparameter verglichen werden, wobei diejenige paarweise Kombination von Koppelpositionen als für diese Frequenz für Messungen an unbekannten Messobjekten bevorzugte erste und zweite Koppelposition gespeichert wird, bei der die Differenz zwischen dem Wert des bestimmten Streuparameters und dem für den Kalibrierstandard bekannten Streuparameter am niedrigsten ist.

Dies hat den Vorteil, dass sich eine verbesserte, breitbandige Messdynamik ergibt, da die erste und zweite Koppelposition für die Messung der Streuparameter aus einer Auswahl von drei oder mehr vorhandenen Koppelpositionen immer so ausgewählt wird, dass die Abweichung des Messwertes vom tatsächlichen Wert bzw. ein Messfehler möglichst gering ist.

Beispielsweise wird als Kalibrierverfahren das SOL-Verfahren mit den Kalibrierstandards "short", "open" und "load" oder das 8Term- oder 12Term-Verfahren oder ein Mehrtorkalibrierverfahren verwendet. Alternativ wird als Kalibrierverfahren das SOLT-, das LLR-, TRM-, das TAN-, das TLN- oder das LNN-Verfahren verwendet.

Um eine möglichst geringe Beeinflussung der elektrischen Eigenschaften des Messobjektes durch die Messung zu erzielen, wird die Auskopplung des HF-Signals an den Koppelstellen bevorzugt kontaktlos, beispielsweise kapazitiv oder induktiv oder gleichzeitig kapazitiv und induktiv oder mittels eines elektrooptischen Messverfahrens, mittels Kraftmikroskopie oder mittels eines elektromagnetischen Messverfahrens durchgeführt. Erfindungsgemäß ist jedes kontaktlose und/oder kontaktbehaftete Verfahren geeignet, welches die elektromagnetische Welle in Betrag und Phase bestimmt.

Eine weitere zusätzliche Koppelstelle erhält man auf einfache Weise beispielsweise dadurch, dass zusätzlich die aus der zweiten elektrischen Leitung ausgekoppelten HF-Signale von wenigstens zwei Koppelstellen zu einem HF-Signal mittels wenigstens einer mathematischen Rechenoperation und/oder wenigstens einem Algorithmus zusammengefasst, insbesondere aufsummiert oder subtrahiert, werden und erst dann an das Messtor zur weiteren Signalverarbeitung übertragen werden.

In einer beispielhaften Ausführungsform wird eine Messsonde verwendet, die sequentiell an den Koppelpositionen positioniert wird.

In einer alternativen Ausführungsform werden pro Messtor zwei oder mehr, insbesondere eine der Koppelpositionen entsprechende Anzahl Messsonden verwendet.

Für eine spätere Fehleranalyse während der Messung an einem unbekannten Messobjekt wird während der Kalibrierung ein mathematischer Zusammenhang zwischen den Messsonden bestimmt und gespeichert.

Bei einem Messverfahren der o.g. Art ist es erfindungsgemäß vorgesehen, dass für jede Frequenz des HF-Testsignals als erste und zweite Koppelposition die für diese Frequenz im zuvor beschriebenen Kalibrierverfahren gespeicherte paarweise Kombination von Koppelpositionen gewählt wird.

Dies hat den Vorteil, dass die Messgenauigkeit für eine große Bandbreite erhöht wird.

Eine weitere Verbesserung der Genauigkeit der Messergebnisse erzielt man dadurch, dass für jede Frequenz des HF-Testsignals zusätzlich zur Bestimmung der Streuparameter unter Verwendung der gespeicherten paarweisen Kombination der Koppelpositionen eine Bestimmung der Streuparameter mit einer oder mehreren paarweise Kombinationen von Koppelpositionen durchgeführt wird, die bei der Kalibrierung gemäß wenigstens einem der Ansprüche 1 bis 11 die nächst größere Differenz zwischen dem Wert des bestimmten Streuparameters und dem für den Kalibrierstandard bekannten Streuparameter aufgewiesen hat bzw. haben als die gespeicherte paarweise Kombination von Koppelpositionen; hierbei wird aus allen für eine Frequenz des HF-Testsignals bestimmten Werten für einen jeweiligen Streuparameter ein Mittelwert für den jeweiligen Streuparameter berechnet. Dies verringert den Einfluss eines Messfehlers beispielsweise aufgrund einer im Vergleich mit der Position bei der Kalibrierung falsch positionierten Koppelposition.

Um eine defekte Messsonde zu detektieren, wird bei der Messung an einem unbekannten Messobjekt der während der Kalibrierung bestimmte mathematische Zusammenhang zwischen mehreren Messsonden erneut bestimmt und mit den bei der Kalibrierung erhaltenen Werten verglichen, wobei in Abhängigkeit von einem Unterschied eine defekte Messsonde erkannt wird.

Bei einer beispielhaften HF-Messvorrichtung, vorgesehen, dass für wenigstens eines der Messtore wenigstens drei voneinander beabstandete Koppelpositionen zum Auskoppeln eines auf einer mit dem Messobjekt verbundenen zweiten elektrischen Leitung, insbesondere einer planaren Leitung, laufenden HF-Signals vorgesehen sind.

Dies hat den Vorteil, dass für jede Messung ein jeweiliges Paar von Koppelpositionen ausgewählt werden kann, welches einen niedrigen Messfehler aufweist.

Für jede Koppelposition kann eine separate, an der jeweiligen Koppelposition angeordnete Messsonde vorgesehen sein.

Alternative kann für jedes Messtor eine einzige Messsonde sowie eine Vorrichtung zum Bewegen dieser Messsonde an die Koppelpositionen vorgesehen sein.

Alternativ ist für jedes Messtor eine Anzahl von Messsonden vorgesehen, die größer gleich zwei und kleiner gleich der Anzahl der Koppelpositionen minus eins ist, wobei die HF-Messvorrichtung wenigstens eine Vorrichtung zum Bewegen wenigstens einer der Messsonden an verschiedene Koppelpositionen aufweist.

Beispielsweise ist wenigstens eine Messsonde als kontaktlose oder kontaktbehaftete Messsonde ausgebildet.

Alternativ ist wenigstens eine der Messsonden kapazitiv oder induktiv oder gleichzeitig kapazitiv und induktiv oder mittels eines elektrooptischen Messverfahrens, mittels Kraftmikroskopie oder mittels eines elektromagnetischen Messverfahrens auskoppelnd ausgebildet.

Die Erfindung wird im Folgenden anhand der Zeichnung näher erläutert. Diese zeigt in:
Fig. 1 ein Simulationsmodell für eine erfindungsgemäße Ein-Tor-Messung,
Fig. 2 eine graphische Darstellung der Systemdynamik für verschiedene Paarungen der Koppelpositionen,
Fig. 3 eine graphische Darstellung der Systemdynamik nach einer erfindungsgemäßen Kalibrierung des Systems,
Fig. 4 ein schematisches Schaltbild einer beispielhaften HF-Messvorrichtung mit einem 2-Tor-Vektorntzwerkanalysator und
Fig. 5 ein schematisches Schaltbild einer weiteren beispielhaften HF-Messvorrichtung mit einem 4-Tor-Vektornetzwerkanalysator.

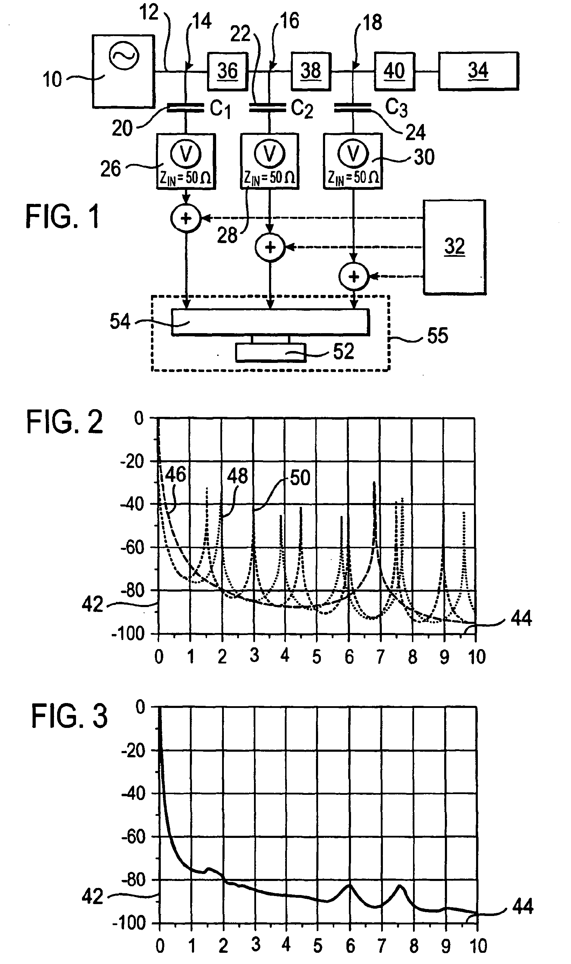

Das in Fig. 1 dargestellte Simulationsmodell einer erfindungsgemäßen Ein-Tor-Messung umfasst eine Signalquelle 10, welche ein HF-Testsignal mit einem Leistungspegel von 1 dBm in eine elektrische Leitung 12 in Form einer verlustfreien 50Ω-Leitung einspeist. Die kontaktlose, in diesem Beispiel kapazitive Ankopplung an drei Koppelpositionen 14, 16, 18 ist durch drei ideale Kondensatoren 20, 22, 24 modelliert. Die kapazitive Ankopplung an den Koppelpositionen 14, 16, 18 ist lediglich beispielhaft. Es können auch induktive Kopplungen oder kapazitive Kopplung und induktive Kopplung gemischt oder jede andere Kopplungsart verwendet werden. Die ausgekoppelten Spannungen werden an Empfängern in Form von Messstellen m₁ 26, m₂ 28 und m₃ 30 mittels 50Ω Systemen bestimmt. Ein Generator 32 für weißes gaußsches Rauschen (WGN = White Gaussian Noise) koppelt in bekannter Weise nach den Messstellen m₁ 26, m₂ 28 und m₃ 30 mit typischerweise -118dBm und 50Ω ein. Ein Messobjekt 34, auch DUT (Device Under Test) genannt, ist mit der elektrischen Leitung 12 verbunden. Ein erster Abschnitt 36 der elektrischen Leitung 12 zwischen der ersten Koppelstelle 14 und der zweiten Koppelstelle 16 hat eine Länge I₁, ein zweiter Abschnitt 38 der elektrischen Leitung 12 zwischen der zweiten. Koppelstelle 16 und der dritten Koppelstelle 18 hat eine Länge I_{2,} und ein dritter Abschnitt 40 der elektrischen Leitung 12 zwischen der dritten Koppelstelle 18 und dem Messobjekt 34 hat eine Länge I₃. Beispielweise haben die vorgenannten Abschnitte 36, 38 der elektrischen Leitung 12 die Längen I₁ = 22 mm, so dass sich für den Abstand zwischen der ersten und zweiten Koppelstelle 14, 16 ein Wert von 22 mm ergibt, und I₂ = 78 mm, so dass sich für den Abstand zwischen der zweiten und dritten Koppelstelle 16, 18 ein Wert von 78 mm ergibt, wobei sich daraus für den Abstand zwischen der ersten und dritten Koppelstelle 14, 18 eine Länge der elektrischen Leitung 12 von I₁ + I₂ = 100 mm ergibt. Bei 52 ist eine herkömmliche Kalibrierung, beispielsweise eine SOL-Kalibrierung, hinterlegt. Bei 54 ist eine weitere Kalibrierung der HF-Messvorrichtung hinterlegt, die nachfolgend beschrieben wird:
Zuerst wird eine herkömmliche SOL-Kalibrierung mit einer 50Ω Last- ("load"), einem Kurzschluss- ("short") und einem Offen-Standard ("open") für jede der drei möglichen Kombinationen von zwei der drei Koppelstellen 14, 16, 18 durchgeführt. Dies ist lediglich beispielhaft. Es kann auch ein anderes Kalibrierverfahren verwendet werden. Anschließend wird für jede Kombination der Koppelstellen 14, 16, 18 für den 50Ω Last-Kalibrierstandard der Wert für den Streuparameter S₁₁ bestimmt. Dies ist lediglich beispielhaft. Es kann auch ein anderer Streuparameter und ein anderer Kalibrierstandard verwendet werden. Wesentlich ist lediglich, dass für die als DUT verwendeten Kalibrierstandards der zu erwartende Wert für den gemessenen Streuparameter bekannt ist. Im vorliegenden Fall wird für den Wert von IS₁₁I in dB bei einem "load" als DUT ein möglichst niedriger Wert erwartet, da in idealer Weise an dem "load" keine Reflexion auftritt.

In Fig. 2 ist für identische kapazitive Messsonden an den Koppelstellen 14, 16, 18 mit einem 50Ω Last-Kalibrierstandard ("load") als DUT der simulierte Streuparameter IS₁₁I in dB (äquivalent zu einem gemessenen Streuparameter) auf der vertikalen Achse 42 über der Frequenz in GHz auf der horizontalen Achse 44 aufgetragen. Diese Darstellung repräsentiert also die simulierte Systemdynamik. Hierbei veranschaulicht ein erster Graph 46 die Werte für IS₁₁I in dB über die Frequenz bei Verwendung der ersten und zweiten Koppelstelle 14, 16, also für die Messstellen m₁ 26 und m₂ 28, ein zweiter Graph 48 die Werte für IS₁₁I in dB über die Frequenz bei Verwendung der zweiten und dritten Koppelstelle 16, 18, also für die Messstellen m₂ 28 und m₃ 30 und ein dritter Graph 50 die Werte für IS₁₁I in dB über die Frequenz bei Verwendung der ersten und dritten Koppelstelle 14, 18, also für die Messstellen m₁ 26 und m₃ 30. Die Abstände I₁ und I₂ zwischen den Koppelstellen 14, 16 und 18 sind gerade so gewählt, dass sich die Maxima der Graphen 46, 48 und 50 nicht überlappen. Zur Kalibrierung des Systems wird nun für jeden Frequenzpunkt diejenige paarweise Kombination von zwei Koppelstellen 14, 16, 18 bestimmt, für die der Streuparameter IS₁₁I in dB den geringsten Abstand bzw. die geringste Differenz von dem erwarteten Wert für IS₁₁I in dB aufweist, d.h. in dem vorliegenden Beispiel den niedrigsten Wert aufweist. Dieses Koppelpositionspaar wird für den entsprechenden Frequenzpunkt als bevorzugtes Koppelpositionspaar abgespeichert und bei einer späteren Messung eines unbekannten Messobjekts bzw. DUT bei der jeweiligen Frequenz verwendet. Dieses Verfahren wird nachfolgend als "Diversitätskalibrierung" bezeichnet. Dementsprechend ist in 52 die SOL-Kalibrierung und in 54 die Diversitätskalibrierung hinterlegt. Insgesamt ist mit 55 die DSOL- also die Diversitäts-SOL-Kalibrierung bezeichnet.

Die aus dieser Diversitätskalibrierung (simuliert) resultierende Systemdynamik ist in Fig. 3 dargestellt. Auf der vertikalen Achse 42 ist der Streuparameter IS₁₁I in dB und auf der horizontalen Achse die Frequenz in GHz aufgetragen. Es ist unmittelbar ersichtlich, dass sich durch die Diversitätskalibrierung die Systemdynamik bei kritischen Frequenzen drastisch verbessert hat. Durch die effiziente Auswahl der Abstände der Koppelstellen 14, 16 und 18 kann ein Gewinn von 70 dB bei 6,8 GHz erzielt werden. Weiterhin resultiert die Diversitätskalibrierung zu einem erweiterten Frequenzbereich für die Brauchbarkeit der Messanordnung.

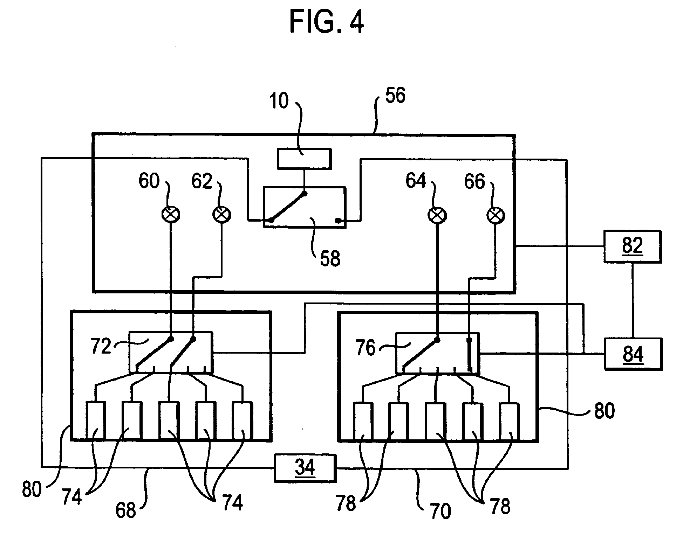

Eine mögliche HF-Messvorrichtung auf Basis eines 2-Tor-Vektornetzwerkanalysators 56 ist in Fig. 4 dargestellt. Der 2-Tor-Vektornetzwerkanalysator 56 umfasst die Signalquelle 10 für ein HF-Testsignal, einen ersten Schalter 58 und vier Messstellen m₁ 60, m₂ 62, m₃ 64 und m₄ 66, je zwei pro Messtor. Der erste Schalter 58 verbindet die Signalquelle 10 wahlweise mit elektrischen Leitungen in Form von vorderer und hinterer planarer Leitung 68, 70, die von verschiedenen Seiten in das DUT 34 münden, so dass vor und hinter dem DUT 34 das Testsignal eingekoppelt werden kann. Die herkömmliche Verbindung der Messstellen m₁ 60, m₂ 62, m₃ 64 und m₄ 66 mit internen Koppelstrukturen des 2-Tor-Vektornetzwerkanalysators 56 zum Auskoppeln der hinund rücklaufenden Welle auf der elektrischen Leitung 12 innerhalb des 2-Tor-Vektornetzwerkanalysators 56 ist getrennt. Stattdessen sind die erste und zweite Messstelle m₁ 60, m₂ 62 über einen zweiten Schalter 72 mit dem ersten Tor des 2-Tor-Vektornetzwerkanalysators 56 zugeordneten fünf Messsonden 74 derart wahlweise verbunden, dass immer je eine der Messsonden 74 mit der ersten Messstelle m₁ 60 und eine andere der Messsonden 74 mit der zweiten Messstelle m₂ 62 verbunden ist. Analog ist ein dritter Schalter 76 vorgesehen, welcher wahlweise dem zweiten Tor des 2-Tor-Vektornetzwerkanalysators 56 zugeordnete weitere fünf Messsonden 78 mit der dritten und vierten Messstelle m₃ 64, m₄ 66 derart verbindet, dass immer je eine der Messsonden 78 mit der dritten Messstelle m₃ 64 und eine der anderen Messsonden 78 mit der vierten Messstelle m₄ 66 verbunden ist. Schalter 72, 76 sowie Messsonden 74, 78 sind jeweils auf einem Substrat 80 angeordnet. Die dem ersten Tor des 2-Tor-Vektornetzwerkanalysators 56 zugeordneten Messsonden 74 sind nahe der vorderen planaren Leitung 68 angeordnet, um an verschiedenen Koppelstellen aus der vorderen planaren Leitung 68 ein HF-Signal auszukoppeln, während die dem zweiten Tor des 2-Tor-Vektornetzwerkanalysators 56 zugeordneten Messsonden 78 nahe der hinteren planaren Leitung 70 angeordnet sind, um an verschiedenen Koppelstellen aus der hinteren planaren Leitung 70 ein HF-Signal auszukoppeln. Die Schalter 72, 76 realisieren die Auswahl von paarweisen Anordnungen der Koppelpositionen, an denen sich die Messsonden 74 und 78 befinden. Eine Steuervorrichtung 82, insbesondere ein Computer, steuert den 2-Tor-Vektornetzwerkanalysators 56 sowie über eine Spannungsquelle 84 die Schalter 72 und 76.

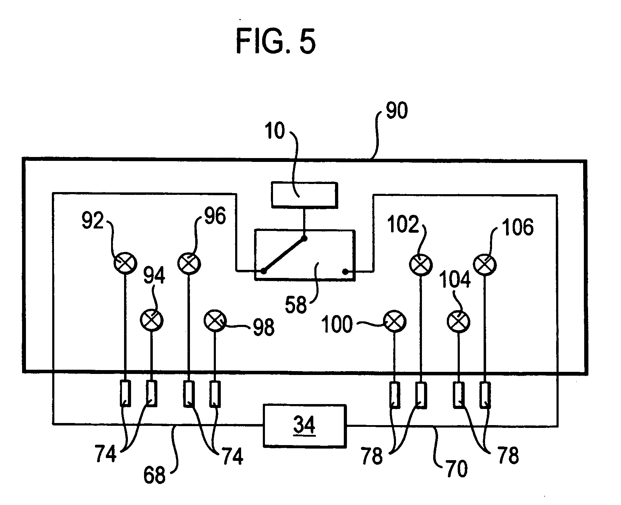

Eine weitere mögliche HF-Messvorrichtung auf Basis eines 4-Tor-Vektornetzwerkanalysators 90 ist in Fig. 5 dargestellt. Der 4-Tor-Vektornetzwerkanalysators 90 umfasst die Signalquelle 10 für ein HF-Testsignal, den ersten Schalter 58 und acht Messstellen m₁ 92, m₂ 94, m₃ 96, m₄ 98, m₅ 100, m₆ 102, m₇ 104 und m₈ 106, je zwei pro Messtor. Die ersten vier Messstellen m₁ 92, m₂ 94, m₃ 96 und m₄ 98 sind jeweils mit einer der Messsonden 74 verbunden, die an Koppelpositionen an der vorderen planaren Leitung 68 angeordnet sind. Die zweiten vier Messstellen m₅ 100, m₆ 102, m₇ 104 und m₈ 106 sind jeweils mit einer der Messsonden 78 verbunden, die an Koppelpositionen an der hinteren planaren Leitung 70 angeordnet sind. Durch die Verwendung der acht Messstellen m₁ 92, m₂ 94, m₃ 96, m₄ 98, m₅ 100, m₆ 102, m₇ 104 und m₈ 106 kann auf den zweiten und dritten Schalter der ersten Ausführungsform gemäß Fig. 4 verzichtet werden. Die Auswahl von je zwei Koppelstellen bzw. von je zwei Messsonden 74 bzw. 78 erfolgt hierbei intern im 4-Tor-Vektornetzwerkanalysator 90, d.h. es ist eine Diversitätskalibrierung in dem Netzwerkanalysator implementiert.

Eine Verbesserung des kontaktlosen Netzwerkanalyseverfahrens stellt die Verwendung von mehr als zwei Messsonden pro Messtor dar. Die durch die zusätzlichen Messsonden gewonnene Redundanz wird zur Verbesserung der Messdynamik verwendet, womit ein breitbandiges Messsystem erzeugt werden kann. Dazu wird bei der Diversitätskalibrierung für jede mögliche Messsondenkombination eine herkömmliche Kalibrierung durchgeführt. Nach der Kalibrierung wird auf die kalibrierte Referenzimpedanz, beispielsweise Loadstandard oder Kalibrierleitung, für jede Sondenpaarkombination zurück gemessen. Aus den kalibrierten Messergebnissen kann auf die Messdynamik geschlossen werden. Innerhalb eines Programmes werden nun für jeden Frequenzpunkt die Dynamikbereiche jeder Messsondenkombination verglichen. Ausgewählt wird jeweils das Sondenpaar, welches die größte Messdynamik aufweist. Die Auswahl der Sondenpaare für jeden Frequenzpunkt wird im Speicher abgelegt und für die Vermessung von unbekannten Messobjekten verwendet.

Zusätzlich können beim kontaktlosen Diversitätsmesssystem auch andere Optimierungskriterien gewählt werden, beispielsweise wird die Redundanz der zusätzlichen Sondenpaarkombinationen zur Erhöhung der Messgenauigkeit genutzt. Beispielsweise können in Frequenzbereichen, in denen mehrere Messsondenpaare eine ähnliche Dynamik aufweisen, die Messergebnisse der Messsonden für eine Messung gemittelt werden. Dies verringert den Einfluss eines Messfehlers beispielsweise einer falsch positionierten Messsonde.

Darüber hinaus kann die Redundanz genutzt werden, um eine defekte oder falsch positionierte Messsonde zu erkennen. Ist eine defekte Sonde erkannt, kann diese für die Messung elektronisch herausgenommen werden oder das Fehlverhalten kann dem Benutzer angezeigt werden. Um eine defekte Messsonde zu detektieren, wird beispielsweise eine mathematische Beziehung zwischen den Messsonden während der Kalibrierung bestimmt. Der mathematische Zusammenhang wird dann während jeder Messung eines unbekannten Messobjektes auf Richtigkeit geprüft.

Die Ausführungsformen der Messsonden sind beliebig. Die Sonden können planar oder dreidimensional realisiert sein, wobei die Sonden nicht identisch sein müssen. Messsonden mit unterschiedlichen Kopplungstypen können kombiniert werden. Für eine kompakte Bauform bietet sich eine planare Realisierung auf einem Substrat an.

Eine Koppelstelle kann auch als Kombination mehrerer Sonden (z. B. Summierung zweier Probemessstellen) aufgefasst werden. Für jeden Frequenzpunkt wird das zur Messung am besten geeignete Probepaar bezüglich z.B. Dynamikverhalten, Messgenauigkeit etc. ausgewählt. Die Auswahl findet bei der Rückmessung auf einen bekannten Standard, wie beispielsweise Load statt.

## Patentansprüche

1. Verfahren zum Kalibrieren einer Hochfrequenz-Messvorrichtung (HF-Messvorrichtung) mit N Messtoren, wobei N eine ganze Zahl ≥ 1 ist, zum Bestimmen von Streuparametern eines Messobjektes mit einer n-Tor Messung, wobei n eine ganze Zahl ≥ 1 ist, wobei in eine mit dem Messobjekt oder mit einer das Messobjekt enthaltenden Schaltung verbundene erste elektrischen Leitung ein Hochfrequenz-Testsignal (HF-Testsignal) eingespeist wird, wobei für jedes Tor von einer mit dem Messobjekt verbundenen zweiten elektrischen Leitung an einer ersten Koppelposition sowie an einer von der ersten Koppelposition beabstandeten zweiten Koppelposition ein über die zweite elektrische Leitung laufendes Hochfrequenzsignal (HF-Signal) ausgekoppelt wird, wobei aus den beiden an den beiden Koppelstellen ausgekoppelten HF-Signalen in jedem Tor jeweils pro Mess- oder Koppelstelle eine Amplitude und/oder eine Phase in Bezug auf das HF-Testsignal eines auf der zweiten elektrischen Leitung zum Messobjekt hinlaufenden HF-Signals sowie eines auf der zweiten elektrischen Leitung von dem Messobjekt weglaufenden HF-Signals bestimmt und daraus Streuparameter des Messobjektes berechnet werden,
**dadurch gekennzeichnet,**
**dass** für wenigstens eines der Tore der HF-Messvorrichtung das auf der zweiten elektrischen Leitung laufende HF-Signal an wenigstens drei voneinander beabstandeten Koppelpositionen ausgekoppelt wird, wobei für jede paarweise Kombination der wenigstens drei Koppelpositionen mit einem vorbestimmten Kalibrierverfahren mit wenigstens einem Kalibrierstandard als Messobjekt, dessen Streuparameter bekannt ist, wenigstens ein Streuparameter für wenigstens eine Frequenz des HF-Testsignals bestimmt wird, wobei die für alle paarweisen Kombinationen bei einer Frequenz des HF-Testsignals bestimmten Werte für den wenigstens einen Streuparameter mit dem für den Kalibrierstandard bekannten Wert für diesen wenigstens einen Streuparameter verglichen werden, wobei diejenige paarweise Kombination von Koppelpositionen als für diese Frequenz für Messungen an unbekannten Messobjekten bevorzugte erste und zweite Koppelposition gespeichert wird, bei der die Differenz zwischen dem Wert des bestimmten Streuparameters und dem für den Kalibrierstandard bekannten Streuparameter am niedrigsten ist.

2. Verfahren nach Anspruch 1, **dadurch gekennzeichnet, dass** die HF-Messvorrichtung ein Vektornetzwerkanalysator ist.

3. Verfahren nach Anspruch 1 oder 2, **dadurch gekennzeichnet, dass** die zweite elektrische Leitung eine planare Leitung ist.

4. Verfahren nach wenigstens einem der vorhergehenden Ansprüche, **dadurch gekennzeichnet, dass** als Kalibrierverfahren das SOL-Verfahren mit den Kalibrierstandards "short", "open" und "load" oder das 8Term- oder 12Term-Verfahren oder ein Mehrtorkalibrierverfahren verwendet wird.

5. Verfahren nach wenigstens einem der vorhergehenden Ansprüche, **dadurch gekennzeichnet, dass** als Kalibrierverfahren das SOLT-, das LLR-, TRM-, das TAN-, das TLN- oder das LNN-Verfahren verwendet wird.

6. Verfahren nach wenigstens einem der vorhergehenden Ansprüche, **dadurch gekennzeichnet, dass** die Auskopplung des HF-Signals an den Koppelstellen kontaktlos durchgeführt wird.

7. Verfahren nach wenigstens einem der vorhergehenden Ansprüche, **dadurch gekennzeichnet, dass** die Auskopplung des HF-Signals an den Koppelstellen kapazitiv oder induktiv oder gleichzeitig kapazitiv und induktiv oder mittels eines elektrooptischen Messverfahrens, mittels Kraftmikroskopie oder mittels eines elektromagnetischen Messverfahrens durchgeführt wird.

8. Verfahren nach wenigstens einem der vorhergehenden Ansprüche, **dadurch gekennzeichnet, dass** zusätzlich die aus der zweiten elektrischen Leitung ausgekoppelten HF-Signale von wenigstens zwei Koppelstellen zu einem HF-Signal mittels wenigstens einer mathematischen Rechenoperation und/oder wenigstens einem Algorithmus zusammengefasst, insbesondere aufsummiert oder subtrahiert, werden und erst dann an das Messtor zur weiteren Signalverarbeitung übertragen werden.

9. Verfahren nach wenigstens einem der vorhergehenden Ansprüche, **dadurch gekennzeichnet, dass** eine Messsonde verwendet wird, die sequentiell an den Koppelpositionen positioniert wird.

10. Verfahren nach wenigstens einem der Ansprüche 1 bis 8, **dadurch gekennzeichnet, dass** pro Messtor zwei oder mehr, insbesondere eine der Koppelpositionen entsprechende Anzahl Messsonden verwendet werden.

11. Verfahren nach Anspruch 10, **dadurch gekennzeichnet, dass** während der Kalibrierung ein mathematischer Zusammenhang zwischen den Messsonden bestimmt und gespeichert wird.

12. Verfahren zum Bestimmen von Streuparametern eines Messobjektes mit einer n-Tor Messung, wobei n eine ganze Zahl ≥ 1 ist, mittels einer Hochfrequenz-Messvorrichtung (HF- Messvorrichtung) mit N Messtoren, wobei N eine ganze Zahl ≥ 1 ist, welche nach wenigstens einem der Ansprüche 1 bis 8 kalibriert ist, wobei in eine mit dem Messobjekt oder mit einer das Messobjekt enthaltenden Schaltung verbundene erste elektrischen Leitung ein Hochfrequenz-Testsignal (HF-Testsignal) eingespeist wird, wobei für jedes Tor von einer mit dem Messobjekt verbundenen zweiten elektrischen Leitung, insbesondere einer planaren Leitung, an einer ersten Koppelposition sowie an einer von der ersten Koppelposition beabstandeten zweiten Koppelposition der zweiten elektrischen Leitung ein über die zweite elektrische Leitung laufendes Hochfrequenzsignal (HF-Signal) ausgekoppelt wird, wobei aus den beiden an den beiden Koppelstellen ausgekoppelten HF-Signalen in jedem Tor jeweils pro Koppelstelle eine Amplitude und/oder eine Phase in Bezug auf das HF-Testsignal eines auf der zweiten elektrischen Leitung zum Messobjekt hinlaufenden HF-Signals sowie eines auf der zweiten elektrischen Leitung von dem Messobjekt weglaufenden HF-Signals bestimmt und daraus Streuparameter des Messobjektes berechnet werden,
**dadurch gekennzeichnet,**
**dass** für jede Frequenz des HF-Testsignals als erste und zweite Koppelposition die für diese Frequenz im Kalibrierverfahren gemäß wenigstens einem der Ansprüche 1 bis 11 gespeicherte paarweise Kombination von Koppelpositionen gewählt wird.

13. Verfahren nach Anspruch 12, **dadurch gekennzeichnet, dass** die HF-Messvorrichtung ein Vektornetzwerkanalysator ist.

14. Verfahren nach Anspruch 12 oder 13, **dadurch gekennzeichnet, dass** die zweite elektrische Leitung eine planare Leitung ist.

15. Verfahren nach einem der Ansprüche 12 bis 14, **dadurch gekennzeichnet, dass** für jede Frequenz des HF-Testsignals zusätzlich zur Bestimmung der Streuparameter unter Verwendung der gespeicherten paarweisen Kombination der Koppelpositionen eine Bestimmung der Streuparameter mit einer oder mehreren paarweise Kombinationen von Koppelpositionen durchgeführt wird, die bei der Kalibrierung gemäß wenigstens einem der Ansprüche 1 bis 11 die nächst größere Differenz zwischen dem Wert des bestimmten Streuparameters und dem für den Kalibrierstandard bekannten Streuparameter aufgewiesen hat bzw. haben als die gespeicherte paarweise Kombination von Koppelpositionen, wobei aus allen für eine Frequenz des HF-Testsignals bestimmten Werten für einen jeweiligen Streuparameter ein Mittelwert für den jeweiligen Streuparameter berechnet wird.

16. Verfahren nach einem der Ansprüche 12 bis 15, **dadurch gekennzeichnet, dass** bei der Messung an einem unbekannten Messobjekt der während der Kalibrierung bestimmte mathematische Zusammenhang zwischen mehreren Messsonden erneut bestimmt und mit den bei der Kalibrierung erhaltenen Werten verglichen wird, wobei in Abhängigkeit von einem Unterschied eine defekte Messsonde erkannt wird.

## Claims

1. Method for calibrating a high frequency measurement device (HF measurement device) comprising N measurement ports, where N is an integer ≥ 1, for determining scattering parameters of a measurement object with an n-port measurement, where n is an integer ≥ 1, wherein a high frequency test signal (HF test signal) is fed into a first electrical lead connected to the measurement object or to a circuit comprising the measurement object, wherein for each port, an HF signal running on a second electrical lead, in particular a planar lead, connected to the measurement object is coupled out from the second electrical lead at a first coupling position and at a second coupling position placed at a distance from the first coupling position, wherein from the two HF signals coupled out at the two coupling positions, in each port, for each measuring site or coupling site, an amplitude and/or a phase, relative to the HF test signal, of an HF signal running on the second electrical lead to the measurement object and of an HF signal running on the second electrical lead away from the measurement object are determined and therefrom, scattering parameters of the measurement object are calculated,
**characterised in that**
for at least one of the ports of the HF measurement device, the HF signal running on the second electrical lead is coupled out at at least three coupling positions placed at a distance from one another, wherein for each pairwise combination of the at least three coupling positions, using a predetermined calibration method with at least one calibration standard as the measurement object, the scattering parameter of which is known, at least one scattering parameter for at least one frequency of the HF test signal is determined, wherein the values determined for all pairwise combinations at one frequency of the HF test signal for the at least one scattering parameter are compared with the known value for the calibration standard for this at least one scattering parameter, wherein that pairwise combination of coupling positions in which the difference between the value of the determined scattering parameter and that known for the calibration standard is at a minimum, is stored as the preferred first and second coupling position for this frequency for measurements on unknown measurement objects.

2. Method according to claim 1, **characterised in that** the HF measurement device is a vector network analyser.

3. Method according to claim 1 or 2, **characterised in that** the second electrical lead is a planar lead.

4. Method according to at least one of the preceding claims, **characterised in that** the calibration method used is the SOL method with the calibration standards "short", "open" and "load" or the 8-term or 12-term method or a multi-port calibration method.

5. Method according to at least one of the preceding claims, **characterised in that** the calibration method used is the SOLT, the LLR, the TRM, the TAN, the TLN or the LNN method.

6. Method according to at least one of the preceding claims, **characterised in that** the coupling out of the HF signal at the coupling sites is carried out contactlessly.

7. Method according to at least one of the preceding claims, **characterised in that** the coupling out of the HF signals at the coupling sites is carried out capacitively or inductively or simultaneously capacitively and inductively or by means of an electro-optical measuring method, by means of a force microscope or by means of an electromagnetic measuring method.

8. Method according to at least one of the preceding claims, **characterised in that** the HF signals coupled out of the second electrical lead from at least two coupling sites are brought together to one HF signal by means of at least one mathematical calculation operation and/or at least one algorithm, particularly added or subtracted, and are only then passed on to the measurement port for further signal processing.

9. Method according to at least one of the preceding claims, **characterised in that** a measuring probe, which is sequentially positioned at the coupling positions, is used.

10. Method according to at least one of the claims 1 to 8, **characterised in that** for each measurement port, two or more measuring probes, and particularly a number corresponding to the coupling positions, are used.

11. Method according to claim 10, **characterised in that** a mathematical relationship between the measuring probes is determined and stored during calibration.

12. Method for determining scattering parameters of a measurement object with an n-port measurement, where n is an integer ≥ 1, by means of a high frequency measurement device (HF measurement device) comprising N measurement ports, where N is an integer ≥ 1, which is calibrated according to at least one of the claims 1 to 8, wherein a high frequency test signal (HF test signal) is fed into a first electrical lead connected to the measurement object or to a circuit comprising the measurement object, wherein for each port, an HF signal running on a second electrical lead, in particular a planar lead, connected to the measurement object is coupled out from the second electrical lead placed at a first coupling position and at a second coupling position of the second electrical lead placed at a distance from the first coupling position, wherein from the two HF signals coupled out at the two coupling positions, in each port, for each coupling site, an amplitude and/or a phase, relative to the HF test signal, of an HF signal running on the second electrical lead to the measurement object and of an HF signal running on the second electrical lead away from the measurement object are determined and therefrom, scattering parameters of the measurement object are calculated,
**characterised in that**
for each frequency of the HF test signal, the pairwise combination of coupling positions stored for this frequency in the calibration method according to at least one of the claims 1 to 11 is selected as the first and second coupling position.

13. Method according to claim 12, **characterised in that** the HF measurement device is a vector network analyser.

14. Method according to claim 12 or 13, **characterised in that** the second electrical lead is a planar lead.

15. Method according to one of the claims 12 to 14, **characterised in that** for each frequency of the HF test signal, in addition to determining the scattering parameters using the stored pairwise combination of coupling positions, determination of the scattering parameters is carried out with one or more pairwise combinations of coupling positions which, during the calibration according to at least one of the claims 1 to 11, has or have produced the next larger difference between the value of the scattering parameter determined and the known scattering parameter for the calibration standard than the stored pairwise combination of coupling positions, wherein from all the values for a particular scattering parameter determined at one frequency of the HF test signal, a mean value is calculated for the respective scattering parameter.

16. Method according to one of the claims 12 to 15, **characterised in that** during measurement of an unknown measurement object, the mathematical relationship between a plurality of measuring probes is determined anew and is compared with the values obtained during the calibration, so that if a difference is detected, a defective measuring probe is thereby identified.

## Revendications

1. Procédé pour le calibrage d'un dispositif de mesure à haute fréquence (dispositif de mesure HF) avec N portes de mesure, telles que N est un nombre entier ≥ 1, pour déterminer des paramètres de dispersion d'un objet mesuré avec une mesure à n portes, telles que n est un nombre entier ≥ 1, dans lequel un signal de test à haute fréquence (signal de test HF) est injecté dans une première ligne électrique connectée à l'objet mesuré ou à un circuit contenant l'objet mesuré, dans lequel un signal à haute fréquence (signal HF) est découplé pour chaque porte depuis une seconde ligne électrique connectée à l'objet mesuré au niveau d'une première position de couplage ainsi qu'à une seconde position de couplage écartée de la première position de couplage, via la seconde ligne électrique, et on détermine, à partir des deux signaux HF découplés au niveau des deux emplacements de couplage dans chaque porte, une amplitude et/ou une phase respective par emplacement de mesure ou de couplage par référence au signal de test HF, d'un signal HF s'approchant sur la seconde ligne électrique vers l'objet mesuré ainsi que d'un signal HF s'éloignant sur la seconde ligne électrique depuis l'objet mesuré et l'on calcule à partir de celle-ci des paramètres de dispersion de l'objet mesuré,
**caractérisé en ce que**
pour l'une au moins des portes du dispositif de mesure HF, on découple le signal HF circulant sur la seconde ligne électrique à au moins trois positions de couplage écartées les unes des autres, et pour chaque combinaison par paire d'au moins trois positions de couplage on détermine, avec un procédé de calibrage prédéterminé avec au moins un standard de calibrage à titre d'objet mesuré dont les paramètres de dispersion sont connus, au moins un paramètre de dispersion pour au moins une fréquence du signal de test HF, et les valeurs déterminées pour toutes les combinaisons par paires à une fréquence du signal de test HF pour ledit au moins un paramètre de dispersion sont comparées avec la valeur connue pour le standard de calibrage pour ledit au moins un paramètre de dispersion, et on mémorise à titre de première et de seconde position de couplage préférées pour cette fréquence pour des mesures sur des objets mesurés inconnus celle des combinaisons par paires de positions de couplage pour laquelle la différence entre la valeur du paramètre de dispersion déterminé et la valeur pour le paramètre de dispersion connu pour le standard de calibrage est la plus faible.

2. Procédé selon la revendication 1, **caractérisé en ce que** le dispositif de mesure HF est un analyseur de réseau vectoriel.

3. Procédé selon la revendication 1 ou 2, **caractérisé en ce que** la seconde ligne électrique est une ligne planaire.

4. Procédé selon l'une au moins des revendications précédentes, **caractérisé en ce que** l'on applique comme procédé de calibrage le procédé dit SOL avec les standards de calibrage "short" (en court-circuit), "open" (ouvert) et "load" (en charge) ou le procédé dit 8-Term ou 12-Term, ou encore un procédé de calibrage à plusieurs portes.

5. Procédé selon l'une au moins des revendications précédentes, **caractérisé en ce que** l'on applique comme procédé de calibrage le procédé SOLT, LLR, TRM, TAN, TLN ou LNN.

6. Procédé selon l'une au moins des revendications précédentes, **caractérisé en ce que** le découplage du signal HF est exécuté sans contact au niveau des emplacements de couplage.

7. Procédé selon l'une au moins des revendications précédentes, **caractérisé en ce que** le découplage du signal HF est exécuté au niveau des emplacements de couplage par voie capacitive ou inductive ou simultanément par voie capacitive et inductive, ou encore au moyen d'un procédé de mesure électro-optique, par microscopie sous effort, ou au moyen d'un procédé de mesure électromagnétique.

8. Procédé selon l'une au moins des revendications précédentes, **caractérisé en ce que** les signaux HF découplés de la seconde ligne électrique provenant d'au moins deux emplacements de couplage sont en supplément regroupés pour donner un signal HF au moyen d'au moins une opération de calcul mathématique et/ou d'au moins un algorithme, en particulier par sommation ou soustraction, et sont transmis uniquement à ce moment à la porte de mesure pour la poursuite du traitement des signaux.

9. Procédé selon l'une au moins des revendications précédentes, **caractérisé en ce que** l'on utilise une sonde de mesure qui est positionnée de manière séquentielle aux positions de couplage.

10. Procédé selon l'une au moins des revendications 1 à 8, **caractérisé en ce que** l'on utilise pour chaque porte de mesure deux ou plusieurs sondes de mesure, en particulier en un nombre correspondant aux positions de couplage.

11. Procédé selon la revendication 10, **caractérisée en ce que** l'on détermine et on mémorise pendant le calibrage une association mathématique entre les sondes de mesure.

12. Procédé pour déterminer des paramètres de diffusion d'un objet mesuré avec une mesure à n portes, tels que n est un nombre entier ≥ 1, au moyen d'un dispositif de mesure à haute fréquence (dispositif de mesure HF) comprenant N portes de mesures, telles que N est un nombre entier ≥ 1, qui est calibré selon l'une au moins des revendications 1 à 8, dans lequel un signal de test à haute fréquence (signal de test HF) est injecté dans une première ligne électrique connectée à l'objet mesuré ou à un circuit contenant l'objet mesuré, et pour chaque porte, un signal haute fréquence (HF) qui circule sur une seconde ligne électrique est découplé depuis la seconde ligne électrique connectée à l'objet mesuré, en particulier une ligne planaire, à une première position de couplage ainsi qu'à une seconde position de couplage, écartée de la première position de couplage, de la seconde ligne électrique, et on détermine à partir des deux signaux HF découplés au niveau des deux emplacements de couplage dans chaque porte et respectivement par emplacement de couplage une amplitude et/ou une phase par référence au signal de test HF d'un signal HF s'approchant sur la seconde ligne électrique vers l'objet mesuré ainsi qu'un signal HF s'éloignant de l'objet mesuré sur la seconde ligne électrique, et on calcule à partir de celle-ci des paramètres de dispersion de l'objet mesuré,
**caractérisé en ce que**
pour chaque fréquence du signal de test HF, on choisit comme première et comme seconde position de couplage la combinaison par paire de positions de couplage qui a été mémorisée pour cette fréquence dans le procédé de calibrage selon l'une au moins des revendications 1 à 11.

13. Procédé selon la revendication 12, **caractérisé en ce que** le dispositif de mesure HF est un analyseur de réseau vectoriel.

14. Procédé selon la revendication 12 ou 13, **caractérisé en ce que** la seconde ligne électrique est une ligne planaire.

15. Procédé selon l'une des revendications 12 à 14, **caractérisé en ce que**, pour chaque fréquence du signal de test HF, en plus de la détermination des paramètres de dispersion avec utilisation de la combinaison par paire mémorisée des positions de couplage, on exécute une détermination des paramètres de dispersion avec une ou plusieurs combinaisons par paires de position de couplage qui, lors du calibrage selon l'une au moins des revendications 1 à 11, présentai(en)t la différence immédiatement inférieure entre la valeur du paramètre de dispersion déterminé et le paramètre de dispersion connu pour le standard de calibrage, à titre de combinaison par paire mémorisée de positions de couplage, et on calcule une valeur moyenne pour le paramètre de dispersion respectif à partir de toutes les valeurs déterminées pour une fréquence du signal de test HF pour un paramètre de dispersion respectif.

16. Procédé selon l'une des revendications 12 à 15, **caractérisé en ce que**, lors de la mesure sur un objet mesuré inconnu, on détermine à nouveau l'association mathématique déterminée pendant le calibrage entre plusieurs sondes de mesure, et on la compare avec les valeurs obtenues lors du calibrage, d'où l'on reconnaît une sonde de mesure défectueuse en fonction d'une différence.
